# EUROPÄISCHE PATENTSCHRIFT

(11) **EP 3 724 981 B1**
(45) Veröffentlichungstag und Bekanntmachung des Hinweises auf die Patenterteilung: **06.04.2022**
(21) Anmeldenummer: 18815688.9
(22) Anmeldetag: 07.12.2018
(51) Int. Cl.: H02M 7/00, H02M 3/158, H02J 1/10, H02J 3/38, H05K 5/02, H05K 7/20, H02S 40/32

(54) **WECHSELRICHTER**
INVERTER
ONDULEUR

(30) Priorität: 15.12.2017 DE 202017107643 U
(43) Veröffentlichungstag der Anmeldung: 21.10.2020
(73) Patentinhaber: SMA Solar Technology AG, 34266 Niestetal (DE)
(72) Erfinder: BUCHHOLD, Stefan, 34131 Kassel (DE); SOEDERBERG, Torsten, 34320 Soehrewald (DE); FRIEBE, Jens, 34246 Vellmar (DE); KOTTHAUS, Michael, 34266 Niestetal (DE); WAPPLER, Thomas, 34302 Guxhagen (DE); MOESER, Ephraim, 34233 Fuldatal (DE)
(86) Internationale Anmeldenummer: PCT/EP2018/084025
(87) Internationale Veröffentlichungsnummer: WO 2019/115403

(56) Entgegenhaltungen:
- CN-U- 206 060 577
- DE-A1-102014 105 985
- DE-T5-112012 003 135
- KR-A- 20160 069 367
- KR-A- 20170 034 781
- US-B1- 6 362 964

## Beschreibung

### TECHNISCHES GEBIET DER ERFINDUNG

Die Erfindung betrifft einen Wechselrichter für eine Photovoltaikanlage.

### STAND DER TECHNIK

Ein Wechselrichter für eine Photovoltaikanlage wandelt einen Gleichstrom eines gleichspannungsseitig angeschlossenen Photovoltaikgenerators in einen Wechselstrom und speist diesen Wechselstrom in ein wechselspannungsseitig an den Wechselrichter angeschlossenes Wechselspannungsnetz ein.

Dabei kann der Photovoltaikgenerator aus lediglich einem Photovoltaikmodul bestehen, das direkt an den Wechselrichter anschließbar ist, wobei der Wechselrichter gegebenenfalls auch direkt an das Photovoltaikmodul montiert oder zumindest in dessen Nähe angeordnet sein kann, insbesondere auf einem Hausdach, auf dem eine Vielzahl von Photovoltaikmodulen mit entsprechend jeweils zugeordneten Wechselrichtern angeordnet sein kann. Man spricht in diesem Fall aufgrund der vergleichsweise geringen elektrischen Leistung eines einzelnen Photovoltaikmoduls (deutlich kleiner als 1 kW) regelmäßig von einem Mikro-Wechselrichter. Ein Nachteil einer derart mit Mikro-Wechselrichtern aufgebauten Photovoltaikanlage besteht in der relativ aufwändigen Wechselstrom-Verkabelung, mit der die Wechselrichter untereinander und mit einem Netzanschlusspunkt des Wechselspannungsnetzes verbunden werden müssen.

Der Photovoltaikgenerator kann auch eine Vielzahl von Photovoltaikmodulen umfassen, die in Reihen- und/oder Parallelschaltung elektrisch miteinander verbunden sind und einen String bilden, wobei die Endpunkte dieses Strings mit gleichspannungsseitigen Anschlüssen eines Wechselrichter verbunden werden können, wie in DE102014105985 beschrieben.

Je nach Anzahl der PhotovoltaiKmodule des Photovoltaikgenerators und damit der vom Wechselrichter umzuwandelnden elektrischen Leistung spricht man hier von String-Wechselrichter (etwa 1 kW bis ca. 100 kW) oder Zentral-Wechselrichter (größer etwa 100 kW). Dabei kann jeder String- bzw. Zentral-Wechselrichter mehrere gleichspannungsseitige Anschlüsse zum Anschluss mehrerer Strings umfassen. Ein Nachteil einer derart mit String- oder Zentral-Wechselrichtern aufgebauten Photovoltaikanlage besteht darin, dass die einzelnen Strings nur gemeinsam vom Wechselrichter gesteuert werden können, insbesondere hinsichtlich einer gemeinsamen Betriebsspannung des Strings und einem etwaigen Abschalten im Fehler- oder Gefahrenfall. Daher ist es in dieser Konfiguration einer Photovoltaikanlage nicht ohne weiteres möglich, die Betriebsspannung einzelner Photovoltaikmodule zu beeinflussen, um einen jeweils optimalen Arbeitspunkt einzustellen, der beispielsweise bei einer Verschattung von Teilen des Strings nicht über die vom Wechselrichter vorgegebene Stringspannung einstellbar ist.

### AUFGABE DER ERFINDUNG

Der Erfindung liegt die Aufgabe zugrunde, einen Wechselrichter bereitzustellen, der die Nachteile der bekannten Lösungen nicht aufweist und Vorteile hinsichtlich der Installation und des Betriebs einer Photovoltaikanlage bietet.

### LÖSUNG

Die Aufgabe wird durch einen Wechselrichter mit den Merkmalen des Patentanspruchs 1 gelöst. Bevorzugte Ausführungsformen sind in den abhängigen Patentansprüchen definiert.

### BESCHREIBUNG DER ERFINDUNG

Ein erfindungsgemäßer Wechselrichter für eine Photovoltaikanlage umfasst eine im Wesentlichen ebene Grundplatte mit einer Vorderseite und einer Rückseite, wobei die Rückseite eine äußere Rückwand des Wechselrichters bildet. Die Grundplatte weist mindestens eine podestförmige Erhöhung auf, die sich in Richtung der Vorderseite der Grundplatte erhebt. Weiterhin umfasst der Wechselrichter eine Leiterplatte mit wärmeerzeugenden Bauteilen, wobei die Leiterplatte auf der Grundplatte montiert ist. Dabei sind die wärmeerzeugenden Bauteile im Bereich der podestförmigen Erhöhung auf der Leiterplatte angeordnet und stehen mit der podestförmigen Erhöhung in thermischem Kontakt, so dass die von den Bauteilen erzeugte Wärme über die Grundplatte effektiv nach außen geführt wird.

Weiterhin umfasst der Wechselrichter eine Vergussmasse, die einen Raum auf der Vorderseite der Grundplatte ausfüllt und die Leiterplatte umschließt, sowie einen Deckel, der auf der Vergussmasse angeordnet an die Grundplatte anschließt, so dass die Grundplatte und der Deckel in Verbindung mit nicht abgedeckten oder außenliegenden Teilen der Vergussmasse ein Gehäuse bilden. Das Gehäuse weist mindestens zwei seitliche Endflächen auf. Darüber hinaus umfasst der Wechselrichter vier Eckbereiche und genau acht Gleichstromanschlüsse, die paarweise zum jeweiligen Anschluss von Photovoltaikmodulen eines Photovoltaikgenerators eingerichtet, an mindestens zwei der seitlichen Endflächen des Gehäuses angeordnet und zumindest teilweise in die Vergussmasse eingegossen sind, wobei die acht Gleichstromanschlüsse in vier Paaren an den vier Eckbereichen des Wechselrichters angeordnet sind, so dass die Photovoltaikmodule um den Wechselrichter herum angeordnet werden können, einen Wechselstromanschluss, der an einer der seitlichen Endflächen des Gehäuses angeordnet ist, wobei elektrische Kontakte des Wechselstromanschlusses mit der Leiterplatte verbunden sind und aus der Vergussmasse herausragen.

Ein derartiger Wechselrichter ist dazu eingerichtet, dass an jeweils einem Paar seiner Gleichstromanschlüsse ein Photovoltaikgenerator bestehend aus mindestens einem Photovoltaikmodul oder einem String aus mehreren Photovoltaikmodulen anschließbar ist. Bevorzugt kann der Wechselrichter derart ausgelegt sein, dass an jedes Paar seiner Gleichstromanschlüsse genau ein Photovoltaikmodul anschließbar ist, indem der Wechselrichter auf eine umzuwandelnde elektrische Leistung ausgelegt ist, die im Wesentlichen der Summe der maximalen Leistungen der anzuschließenden Photovoltaikmodule entspricht. Dies bedeutet einerseits, dass der Wechselrichter auf eine vergleichsweise kleine Leistung im Bereich einiger 100 Watt bis wenige Kilowatt ausgelegt und insofern sehr kompakt gebaut sein kann. Andererseits kann der Wechselrichter aufgrund seiner kompakten Bauform in unmittelbarer Nähe der anzuschließenden Photovoltaikmodule montiert werden, insbesondere direkt an einem Photovoltaikmodul oder an einem Gestell, auf dem die Photovoltaikmodule montiert sind. Dadurch kann die Länge von Gleichstromleitungen zwischen den Photovoltaikmodulen und dem Wechselrichter minimiert werden. Wenn an den Wechselrichter mindestens zwei Photovoltaikmodule angeschlossen werden, ergibt sich ein guter Kompromiss mit minimal kurzen Gleichstromleitungen und einer im Vergleich zu einem Aufbau mit bekannten Mikrowechselrichtern deutlich vereinfachten Wechselstromverkabelung. Dieser Vorteil kommt insbesondere bei einem Wechselrichter mit acht Gleichstromanschlüssen zum Anschluss von vier Photovoltaikmodulen zum Tragen, indem die Photovoltaikmodule um den Wechselrichter herum angeordnet werden, so dass der Wechselrichter im Bereich der Ecke, an der die vier Photovoltaikmodule zusammenstoßen, montiert werden kann und damit für alle vier Photovoltaikmodule einen Anschluss mit kurzen Anschlussleitungen erlaubt. Hierzu sind die acht Gleichstromanschlüsse in vier Paaren an den vier Eckbereichen des Wechselrichters angeordnet.

Eine kompakte Bauform sowie eine einfache Montage des Wechselrichters ergeben sich zudem aus der geringen Anzahl benötigter Bauteile. Im einfachsten Fall kann eine vorgefertigte Leiterplatte auf der Grundplatte fixiert werden, der Deckel auf die Grundplatte gesetzt werden und abschließend der Raum zwischen Grundplatte und Deckel mit der Vergussmasse ausgefüllt werden. Die Gleichstrom- und Wechselstromanschlüsse können dabei bereits vor der Montage mit der Leiterplatte elektrisch verbunden sein.

Durch die Verwendung der Vergussmasse ist es insbesondere nicht mehr notwendig, den Deckel derart mit der Grundplatte zu verbinden, dass ein hermetisch abgeschlossener Innenraum für die elektrischen und elektronischen Bauteile des Wechselrichters entsteht, in dem die elektrischen und elektronischen Bauteile des Wechselrichters vor äußeren Umgebungseinflüssen geschützt sind. Vielmehr schützt die Vergussmasse die elektrischen und elektronischen Bauteile des Wechselrichters bereits in einem ausreichenden Maße und sorgt gleichzeitig für eine verbesserte Entwärmung der Bauteile auf der Leiterplatte. Der Deckel des Wechselrichters kann zudem zusammen mit der Grundplatte eine Vergussform für die Vergussmasse darstellen, sodass die Vergussmasse direkt in den Raum zwischen Deckel und Grundplatte eingefüllt werden kann. Alternativ kann die Grundplatte mit der darauf montierten Leiterplatte und gegebenenfalls mit den Gleichstrom- und Wechselstromanschlüssen in einer separaten Vergussform mit der Vergussmasse vergossen und der Deckel nachträglich auf der Vergussmasse montiert werden. Sofern der Deckel aus einem elektrisch leitfähigen Material besteht oder mit einem solchen beschichtet ist, dient der Deckel zudem als elektromagnetische Abschirmung.

Zur Montage des Wechselrichters an einem Photovoltaikmodul oder einem Gestell eines Photovoltaikgenerators kann der Wechselrichter eine Befestigungslasche aufweisen, die derart an dem Deckel oder an der Grundplatte des Wechselrichters angeordnet ist, dass sie seitlich über das Gehäuse des Wechselrichters hinaus ragt. Die Befestigungslasche kann dabei als Teil der Grundplatte oder des Deckels oder als ein separates Teil ausgebildet sein und Mittel zur Aufnahme von Befestigungsmitteln aufweisen, insbesondere Bohrungen oder Nuten zur Aufnahme von Schrauben, zum Verrasten mit korrespondierenden Raststrukturen, zum Einhängen in Haken oder ähnliches. Eine derartige Befestigungslasche kann zudem die Montage des Wechselrichters vereinfachen, indem der Wechselrichter während seiner Montage mittels der Befestigungslasche fixiert werden kann.

Der Wechselstromanschluss des Wechselrichters kann als Kabelverschraubung ausgeführt sein. Eine Kabelverschraubung ermöglicht es, ein Wechselstromkabel, das mehrere Adern umfasst, auf einfache Weise mit den elektrischen Kontakten des Wechselstromanschlusses und damit mit der Leiterplatte zu verbinden, wobei diese Verbindung durch die Kabelverschraubung hinreichend dicht gegenüber der Umgebung ist.

In einer Ausführungsform des Wechselrichters können je zwei Paare von Gleichstromanschlüssen in Reihe oder parallel mit einem auf der Leiterplatte angeordneten Hochsetzsteller verbunden sein. Dadurch ist der Wechselrichter in der Lage, einen gemeinsamen Arbeitspunkt der an die Gleichstromanschlüsse angeschlossenen Photovoltaikmodul in einem weiten Spannungsbereich einzustellen.

Weiterhin kann der Wechselrichter mindestens zwei Hochsetzsteller umfassen, deren Ausgang gemeinsam elektrisch parallel geschaltet und mit einer auf der Leiterplatte angeordneten Wechselrichterbrückenschaltung verbunden ist. Dadurch ist der Wechselrichter in der Lage, mehrere an die Gleichstromanschlüsse angeschlossene Photovoltaikmodule unabhängig voneinander zu steuern sowie gegebenenfalls spannungsfrei zu schalten.

Aufgrund der kompakten Bauweise des Wechselrichters können weitere Bauteile im Wechselrichter, d.h. im Gehäuse bzw. in der Vergussmasse des Wechselrichters angeordnet werden. Insbesondere kann auf der Leiterplatte eine Netztrennstelle angeordnet sein, die mindestens ein Relais umfasst. Zusätzlich kann der Wechselrichter eine Kommunikationseinheit umfassen, die zur Powerline-Kommunikation über die Gleichstromanschlüsse und/oder den Wechselstromanschluss eingerichtet ist.

### KURZBESCHREIBUNG DER FIGUREN

Im Folgenden wird die Erfindung anhand in den Figuren dargestellter Ausführungsbeispiele weiter erläutert und beschrieben.
- Fig. 1: zeigt eine Ausführungsform des erfindungsgemäßen Wechselrichters in einer Explosionsdarstellung,
- Fig. 2: zeigt eine weitere Ausführungsform des erfindungsgemäßen Wechselrichters in einem montiert Zustand, und
- Fig. 3: zeigt eine weitere Ausführungsform des erfindungsgemäßen Wechselrichters in einer Schnittdarstellung.

### FIGURENBESCHREIBUNG

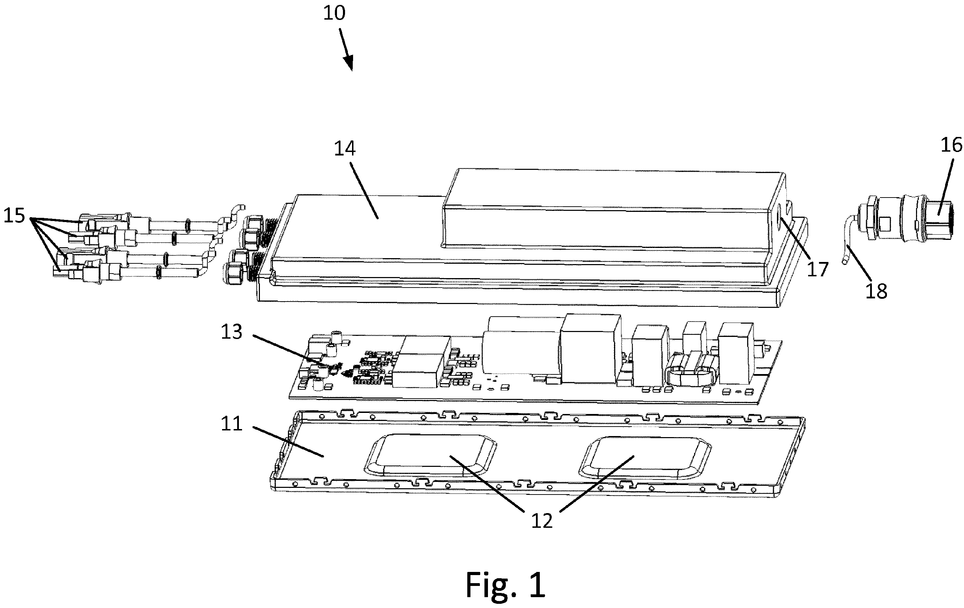

**Fig. 1** zeigt einen Wechselrichter 10 für eine Photovoltaikanlage in einer Explosionsdarstellung. Der Wechselrichter 10 umfasst eine im Wesentlichen ebene Grundplatte 11, dessen Rückseite (in Fig. 1 nicht sichtbar) eine äußere Rückwand des Wechselrichters 10 bildet. Die Grundplatte 11 weist podestförmige Erhöhungen 12 auf, die sich in Richtung der Vorderseite der Grundplatte erheben. Weiterhin umfasst der Wechselrichter 10 eine Leiterplatte 13, die auf der Grundplatte 11 montiert ist und elektrische und elektronische Bauteile umfasst, die zur Erzeugung eines Wechselstroms aus einem Gleichstrom eingerichtet sind. Einige der Bauteile auf der Leiterplatte 13, beispielsweise Halbleiterschalter einer Wechselrichterbrückenschaltung oder Spulen und Drosseln, erzeugen im Betrieb des Wechselrichters 10 Verluste, die in Wärme umgewandelt und aus dem Inneren des Wechselrichters 10 abgeführt werden müssen. Diese wärmeerzeugenden Bauteile, insbesondere die Halbleiterschalter, sind auf der Leiterplatte 13 im Bereich der podestförmigen Erhöhungen 12 so montiert, dass ein thermischer Kontakt zwischen den wärmeerzeugenden Bauteilen besteht, während der Rest der Leiterplatte, der sich außerhalb der Bereiche der podestförmigen Erhöhungen 12 befindet, keinen thermischen Kontakt mit der Grundplatte 11 aufweist.

Weiterhin umfasst der Wechselrichter 10 einen Deckel 14, der an die Grundplatte 11 anschließt ist und insbesondere auf der Grundplatte 11 aufliegen kann. Der Raum zwischen der Vorderseite der Grundplatte 11 und dem Deckel 14 kann vollständig mit einer Vergussmasse ausgefüllt sein (hier nicht dargestellt), wobei die Vergussmasse insbesondere die Leiterplatte umschließt, d.h. beide Seiten der Leiterplatte 13 weitgehend vollständig bedeckt, ggf. mit Ausnahme der Verbindungsflächen zwischen der Leiterplatte 13 bzw. den wärmeerzeugenden Bauteilen darauf und den podestförmigen Erhöhungen 12 der Grundplatte 11. Die Grundplatte 11 und der Deckel 14 bilden somit ein zumindest die Leiterplatte 13 im Wesentlichen vollständig umschließendes Gehäuse, wobei dieses Gehäuse auch die Vergussmasse vollständig umschließt. Alternativ oder zusätzlich kann ein Teil des Gehäuses, insbesondere ein Teil des Deckels 14 ebenfalls von der Vergussmasse umschlossen sein, so dass eine Außenfläche des Wechselrichters 10 von der Vergussmasse gebildet wird.

Weiterhin umfasst der Wechselrichter 10 Gleichstromanschlüsse 15, die paarweise vorgesehen sind, wobei je ein Anschluss eines Anschlusspaares zur Verbindung mit einem positiven Pol und der jeweils andere Anschluss eines Anschlusspaares zur Verbindung mit einem negativen Pol einer Gleichstromquelle eingerichtet sind. Die Gleichstromanschlüsse 15 sind in einem zusammengebauten Zustand des Wechselrichters 10 an einer seitlichen Endfläche des Gehäuses in entsprechenden Löchern im Deckel 14 angeordnet und ragen derart in das Gehäuse, dass sie von der zwischen Grundplatte 11 und Deckel 14 befindlichen Vergussmasse teilweise umschlossen sind, insbesondere indem die Gleichstromanschlüsse 15 teilweise und die elektrische Verbindungen zwischen den Gleichstromanschlüssen 15 und der Leiterplatte 13 gegebenenfalls komplett in die Vergussmasse eingegossen sind.

Weiterhin umfasst der Wechselrichter 10 einen Wechselstromanschluss 16, der ebenfalls an einer seitlichen Endfläche des Gehäuses angeordnet ist und durch ein Loch 17 im Deckel 14 in die Vergussmasse erstreckt, insbesondere indem der Wechselstromanschluss 16 zumindest teilweise in die Vergussmasse eingegossen ist. Der Wechselstromanschluss 16 ist zur Verbindung des Wechselrichter 10 mit einem Wechselspannungsnetz vorgesehen, wobei der Wechselspannungsanschluss 16 elektrische Kontakte 18 umfasst, die mit der Leiterplatte 13 verbunden sind und an die einzelne Leiter des anzuschließenden Wechselspannungsnetzes anschließbar sind.

Es versteht sich, dass die Anschlüsse des Wechselrichters 10, insbesondere die Gleichstromanschlüsse 15 und Wechselstromanschlüsse 16 nicht vollständig von der Vergussmasse umschlossen sind, um von außen Zugriff auf diese Anschlüsse zu haben und Gleichstrom- bzw. Wechselstromleitungen daran anschließen zu können.

Der Wechselspannungsanschluss 16 kann insbesondere als Kabelverschraubung ausgeführt sein, wobei ein Gewindeteil der Kabelverschraubung durch das Loch 17 im Deckel aus dem Gehäuse herausragt und ein Gegenstück der Kabelverschraubung von außerhalb des Gehäuses auf den Gewindeteil aufgeschraubt werden kann.

Der Wechselrichter 10 kann derart ausgeführt sein, dass je zwei Paare der Gleichstromanschlüsse 15 in Reihe oder parallel geschaltet und insofern paarweise mit einem auf der Leiterplatte 13 angeordneten Hochsetzsteller verbunden sind, der insbesondere eine Gleichstromspannung an den Gleichstromanschlüsse 15 regeln kann.

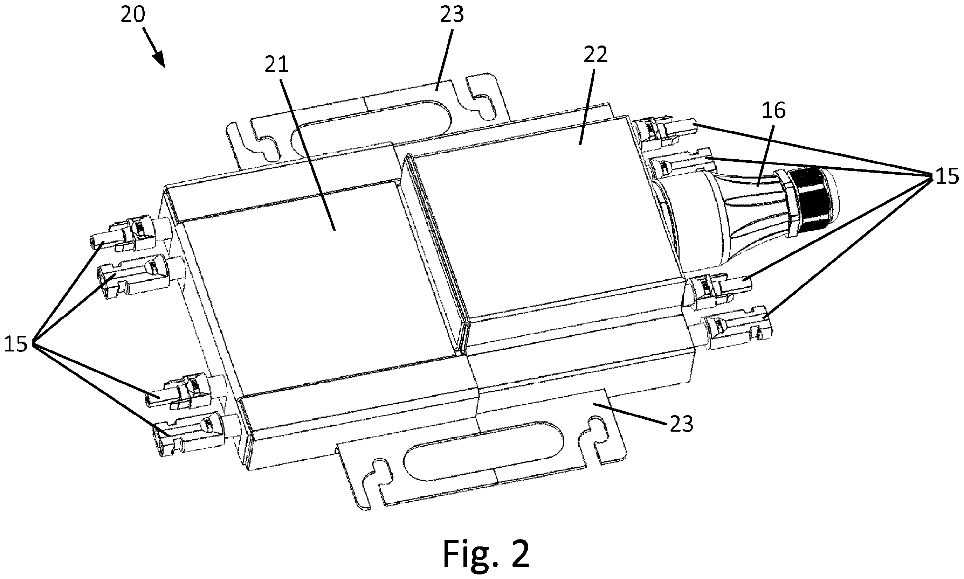

**Fig. 2** zeigt eine weitere Ausführungsform eines Wechselrichters 20 für eine Photovoltaikanlage in einer betriebsfertig montierten Darstellung. Der Wechselrichter 20 umfasst wiederum Gleichstromanschlüsse 15, die paarweise an seitlichen Endfläche des Gehäuses des Wechselrichters 20 angeordnet sind, sowie einen Wechselstromanschluss 16 an einer seitlichen Endfläche des Gehäuses des Wechselrichters 20, wobei das Gehäuse des Wechselrichter 20 gemäß Fig. 2 durch eine Grundplatte (nicht sichtbar), einen Deckel 21 sowie eine Vergussmasse 22 gebildet wird. Die elektrischen und elektronischen Bauteile des Wechselrichters 20 sind analog zu denen des Wechselrichters 10 gemäß Fig. 1 auf einer Leiterplatte angeordnet, die sich unter dem Deckel 21 und im Inneren der Vergussmasse 22 befindet. Die Vergussmasse 22 erstreckt sich dabei auch in einen Bereich zwischen dem Deckel 21 und der Grundplatte und umschließt insbesondere auch die Gleichstromanschlüsse 15 und den Wechselstromanschluss 16 jeweils zumindest teilweise. Es versteht sich, dass der Deckel 21, der gemäß Fig. 2 nur einen Teil der Vergussmasse 22 überdeckt, auch so ausgestaltet sein kann, dass er die gesamte Vergussmasse 22 bedeckt und somit die komplette der Grundplatte gegenüberliegende Oberfläche des Wechselrichters 20 bildet.

Der Wechselrichter 20 weist weiterhin Befestigungslaschen 23 auf, die an dem Deckel 21 oder an der Grundplatte des Wechselrichters 20 angeordnet sein können und seitlich über die Vergussmasse 22 hinausragen. Die Befestigungslaschen 23 weisen Mittel zu Befestigung des Wechselrichter 23 an einer Wand, einem Gestell oder auch direkt an einem Photovoltaikmodul auf, wobei diese Mittel in Fig. 2 beispielhaft als Nuten zur Aufnahme von Schrauben ausgebildet sind.

Der Wechselrichter 20 umfasst insgesamt vier Paare von Gleichstromanschlüssen 15, an die insgesamt vier einzelne Photovoltaikmodule oder Strings aus Photovoltaikmodulen angeschlossen werden können. Dabei können je zwei Paare von Gleichstromanschlüssen 15 in Reihe oder parallel mit je einem auf der Leiterplatte innerhalb des Wechselrichters 20 angeordneten Hochsetzsteller verbunden sein. Weiterhin kann der Wechselrichter 20 zwei Hochsetzsteller umfassen, die parallel mit einer Wechselrichterbrückenschaltung im Inneren des Wechselrichters 20 verbunden sind.

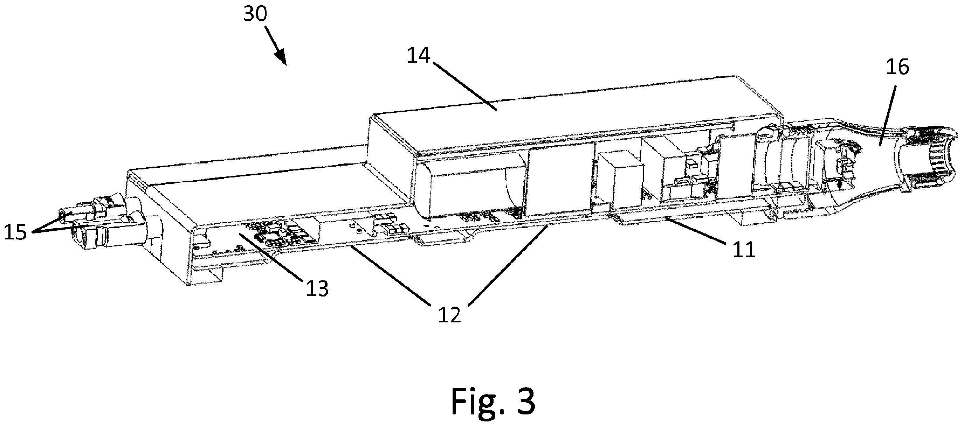

**Fig. 3** zeigt eine Ausführungsform eines Wechselrichters 30 für eine Photovoltaikanlage in einer Schnittdarstellung. Der Wechselrichter 30 umfasst wiederum Gleichstromanschlüsse 15, die paarweise an seitlichen Endfläche des Gehäuses des Wechselrichters 30 angeordnet sind, sowie einen Wechselstromanschluss 16 an einer seitlichen Endfläche des Gehäuses des Wechselrichters 30, wobei das Gehäuse des Wechselrichter 30 gemäß Fig. 3 durch die Grundplatte 11 und den Deckel 14 gebildet wird. Der Zwischenraum zwischen der Grundplatte 11 und dem Deckel 14 kann vollständig mit einer Vergussmasse ausgefüllt sein (in Fig. 3 nicht sichtbar). Die elektrischen und elektronischen Bauteile des Wechselrichters 30 sind analog zu denen der Wechselrichter 10 und 20 gemäß der Figs. 1 und 2 auf einer Leiterplatte 13 angeordnet, die sich im Inneren der Vergussmasse befindet. Die Leiterplatte 13 ist auf der Grundplatte 11 montiert, wobei wärmeerzeugende Bauteile des Wechselrichters 30 derart auf der Leiterplatte 11 angeordnet sind, dass sie sich im Bereich der podestförmigen Erhöhungen 12 der Grundplatte 11 befinden und damit in thermischem Kontakt zur Grundplatte 11 stehen, wodurch eine gute Ableitung der durch die Bauteile erzeugten Wärme an die Umgebung gewährleistet ist.

Darüber hinaus können auf der Leiterplatte 13 eine Netztrennstelle, insbesondere ein Netztrennrelais, und/oder mindestens eine Kommunikationseinheit, die zur Powerline-Kommunikation über die Gleichstromanschlüsse 15 und/oder den Wechselstromanschluss 16 eingerichtet ist, angeordnet sein. Dies gilt selbstverständlich für alle dargestellte Wechselrichter 10, 20, 30 gemäß der Figuren 1-3.

### Bezugszeichenliste

10, 20, 30 Wechselrichter
11 Grundplatte
12 Erhöhungen
13 Leiterplatte
14 Deckel
15 Gleichstromanschluss
16 Wechselstromanschluss
17 Loch
18 Kontakt
21 Deckel
22 Vergussmasse
23 Befestigungslasche

## Patentansprüche

1. Wechselrichter (20) für eine Photovoltaikanlage, umfassend:
- eine im Wesentlichen ebene Grundplatte (11) mit einer Vorderseite und einer Rückseite, wobei die Rückseite eine äußere Rückwand des Wechselrichters (10, 20, 30) bildet, und mit mindestens einer podestförmigen Erhöhung (12), die sich in Richtung der Vorderseite der Grundplatte (11) erhebt,
- eine Leiterplatte (13) mit wärmeerzeugenden Bauteilen, wobei die Leiterplatte (13) derart auf der Grundplatte (11) montiert ist, dass die wärmeerzeugenden Bauteile im Bereich der podestförmigen Erhöhung (12) auf der Leiterplatte (13) angeordnet sind und mit der podestförmigen Erhöhung (12) in thermischen Kontakt stehen,
- eine Vergussmasse (22), die einen Raum auf der Vorderseite der Grundplatte (11) ausfüllt und die Leiterplatte (13) umschließt,
- einen Deckel (21), der auf der Vergussmasse (22) angeordnet ist, an die Grundplatte (11) anschließt und die Vergussmasse (22) teilweise umschließt, so dass die Grundplatte (11) und der Deckel (21) in Verbindung mit nicht abgedeckten Teilen der Vergussmasse (22) ein Gehäuse bilden, wobei das Gehäuse mindestens zwei seitliche Endflächen aufweist,
- vier Eckbereiche,
- genau acht Gleichstromanschlüsse (15), die paarweise zum jeweiligen Anschluss von Photovoltaikmodulen eines Photovoltaikgenerators eingerichtet, an mindestens zwei der seitlichen Endflächen des Gehäuses angeordnet und zumindest teilweise in die Vergussmasse (22) eingegossen sind, wobei die acht Gleichstromanschlüsse in vier Paaren an den vier Eckbereichen des Wechselrichters angeordnet sind, so dass die Photovoltaikmodule um den Wechselrichter herum angeordnet werden können,
- einen Wechselstromanschluss (16), der an einer der seitlichen Endflächen des Gehäuses angeordnet ist, wobei elektrische Kontakte (18) des Wechselstromanschlusses (16) mit der Leiterplatte (13) verbunden sind und aus der Vergussmasse (22) herausragen.

2. Wechselrichter (20) nach Anspruch 1, wobei mindestens eine Befestigungslasche (23) an dem Deckel (21) oder an der Grundplatte (11) derart angeordnet ist, dass sie seitlich über das Gehäuse des Wechselrichter (20) hinausragt, wobei die Befestigungslasche (23) Mittel zur Aufnahme von Befestigungsmitteln aufweist.

3. Wechselrichter (20) nach Anspruch 1 oder 2, wobei der Wechselstromanschluss (16) als Kabelverschraubung ausgeführt ist.

4. Wechselrichter (20) nach einem der vorangehenden Ansprüche, wobei je zwei Paare von Gleichstromanschlüssen (15) in Reihe oder parallel mit einem auf der Leiterplatte (13) angeordneten Hochsetzsteller verbunden sind.

5. Wechselrichter (20) nach einem der vorangehenden Ansprüche, der mindestens zwei Hochsetzsteller umfasst, deren Ausgang miteinander elektrisch parallel geschaltet und mit einer auf der Leiterplatte (13) angeordneten Wechselrichterbrückenschaltung verbunden ist.

6. Wechselrichter (20) nach einem der vorangehenden Ansprüche, der eine auf der Leiterplatte (13) angeordnete Netztrennstelle umfasst.

7. Wechselrichter (20) nach einem der vorangehenden Ansprüche, der mindestens eine Kommunikationseinheit umfasst, die zur Powerline-Kommunikation über die Gleichstromanschlüsse (15) und/oder den Wechselstromanschluss (16) eingerichtet ist.

## Claims

1. An inverter (20) for a photovoltaic system, comprising:
- a substantially planar base plate (11) having a front side and a rear side, the rear side forming an outer rear wall of the inverter (20), and having at least one pedestal-shaped elevation (12) rising towards the front side of the base plate (11),
- a printed circuit board (13) with heat-generating components, the printed circuit board (13) being mounted on the base plate (11) in such a way that the heat-generating components are arranged on the printed circuit board (13) in the region of the pedestal-shaped elevation (12) and are in thermal contact with the pedestal-shaped elevation (12),
- a potting compound (22) which fills a space on the front side of the base plate (11) and encloses the printed circuit board (13)
- a cover (21) which is arranged on the potting compound (22), adjoins the base plate (11) and partially encloses the potting compound (22), so that the base plate (11) and the cover (21), in conjunction with uncovered parts of the potting compound (22), form a housing, the housing having at least two lateral end surfaces,
- four corner areas,
- exactly eight DC terminals (15), arranged in pairs for the respective connection of photovoltaic modules of a photovoltaic generator, arranged on at least two of the lateral end faces of the housing and at least partially encapsulated in the potting compound (22), the eight DC terminals being arranged in four pairs on the four corner regions of the inverter, so that the photovoltaic modules can be arranged around the inverter,
- an AC terminal (16) arranged on one of the lateral end faces of the housing, electrical contacts (18) of the AC terminal (16) being connected to the circuit board (13) and protruding from the potting compound (22).

2. The inverter (20) according to claim 1, wherein at least one fastening lug (23) is arranged on the cover (21) or on the base plate (11) in such a way that it protrudes laterally beyond the housing of the inverter (20), the fastening lug (23) having means for receiving fastening means.

3. The inverter (20) according to claim 1 or 2, wherein the AC connection (16) is designed as a cable gland.

4. The inverter (20) according to one of the preceding claims, wherein two pairs each of DC terminals (15) are connected in series or in parallel to a step-up converter arranged on the printed circuit board (13).

5. The inverter (20) according to any one of the preceding claims, comprising at least two boost converters whose output is electrically connected in parallel with each other and connected to an inverter bridge circuit arranged on the printed circuit board (13).

6. The inverter (20) according to any one of the preceding claims, comprising a mains disconnection point arranged on the printed circuit board (13).

7. The inverter (20) according to any one of the preceding claims, comprising at least one communication unit arranged for powerline communication via the DC terminals (15) and/or the AC terminal (16).

## Revendications

1. Onduleur (20) pour une installation photovoltaïque, comprenant :
- une plaque de base (11) sensiblement plane avec une face avant et une face arrière, la face arrière formant une paroi arrière extérieure de l'onduleur (10, 20, 30), et avec au moins une élévation (12) en forme de podium qui s'élève en direction de la face avant de la plaque de base (11),
- une carte imprimée (13) avec des composants générant de la chaleur, la carte imprimée (13) étant montée sur la plaque de base (11) de telle sorte que les composants générant de la chaleur sont disposés sur la carte imprimée (13) dans la zone de l'élévation en forme de podium (12) et sont en contact thermique avec l'élévation en forme de podium (12),
- une masse de scellement (22) qui remplit un espace sur la face avant de la plaque de base (11) et qui entoure la carte imprimée (13),
- un couvercle (21), qui est disposé sur la masse de scellement (22), se raccorde à la plaque de base (11) et entoure partiellement la masse de scellement (22), de sorte que la plaque de base (11) et le couvercle (21) forment un boîtier en liaison avec des parties non recouvertes de la masse de scellement (22), le boîtier présentant au moins deux surfaces d'extrémité latérales,
- quatre zones d'angle,
- exactement huit bornes de courant continu (15), qui sont aménagées par paires pour le raccordement respectif de modules photovoltaïques d'un générateur photovoltaïque, sont disposés sur au moins deux des surfaces d'extrémité latérales du boîtier et sont au moins partiellement coulés dans la masse de scellement (22), les huit bornes de courant continu étant disposées par quatre paires sur les quatre zones de coin de l'onduleur, de sorte que les modules photovoltaïques peuvent être disposés autour de l'onduleur,
- une borne de courant alternatif (16) disposée sur l'une des surfaces d'extrémité latérales du boîtier, des contacts électriques (18) de la borne de courant alternatif (16) étant reliés à la carte imprimée (13) et dépassant de la masse de scellement (22).

2. Onduleur (20) selon la revendication 1, dans lequel au moins une patte de fixation (23) est disposée sur le couvercle (21) ou sur la plaque de base (11) de telle sorte qu'elle dépasse latéralement du boîtier de l'onduleur (20), la patte de fixation (23) présentant des moyens pour recevoir des moyens de fixation.

3. Onduleur (20) selon la revendication 1 ou 2, dans lequel la borne au courant alternatif (16) est réalisé sous forme de presse-étoupe.

4. Onduleur (20) selon l'une des revendications précédentes, dans lequel deux paires de bornes de courant continu (15) sont chacune reliées en série ou en parallèle à un convertisseur élévateur disposé sur la carte imprimée (13).

5. Onduleur (20) selon l'une quelconque des revendications précédentes, comprenant au moins deux élévateurs dont la sortie est connectée électriquement en parallèle l'une avec l'autre et connectée à un circuit en pont d'onduleur disposé sur la carte imprimée (13).

6. Onduleur (20) selon l'une des revendications précédentes, comprenant un point de coupure du réseau disposé sur la carte imprimée (13).

7. Onduleur (20) selon l'une des revendications précédentes, comprenant au moins une unité de communication agencée pour communiquer par courant porteur en ligne (CPL) via les bornes de courant continu (15) et/ou la borne de courant alternatif (16).
